# EUROPÄISCHE PATENTANMELDUNG

(11) **EP 0 957 430 A1**
(43) Veröffentlichungstag der Anmeldung: **17.11.1999**
(21) Anmeldenummer: 99109553.0
(22) Anmeldetag: 12.05.1999
(51) Int. Cl.: G06F 11/20

(54) **Anordnung zur Redundanzauswertung bei einem Halbleiterspeicherchip**

(30) Priorität: 13.05.1998 DE 19821459
(71) Anmelder: SIEMENS AKTIENGESELLSCHAFT, 80333 München (DE)
(72) Erfinder: Heyne, Patrick, 81541 München (DE); Haerle, Dieter, 81541 München (DE)

(57) **Zusammenfassung**

Die Erfindung betrifft eine Anordnung zur Redundanzauswertung bei einem Halbleiterspeicherchip (1), mit Speicherzellen, die matrixartig in einem Speicherfeld (2) angeordnet sind, das über einen ersten und einen zweiten Decoder (5, 6) ansteuerbar ist. Außerdem sind redundante Speicherzellen (7) vorhanden, die bei Ausfall von Speicherzellen des Speicherfeldes (2) deren Funktion übernehmen. Die Zuordnung zwischen redundanten Speicherzellen (7) und ausgefallenen Speicherzellen des Speicherfeldes (2) ist in einem nichtflüchtigen Speicher (8) permanent abspeicherbar.

## Beschreibung

Die vorliegende Erfindung betrifft eine Anordnung zur Redundanzauswertung bei einem Halbleiterspeicherchip, mit Speicherzellen, die matrixartig in einem Speicherfeld angeordnet sind, das über einen ersten und einen zweiten Decoder ansteuerbar ist, und mit redundanten Speicherzellen, die bei Ausfall von Speicherzellen des Speicherfeldes deren Funktion übernehmen.

Halbleiterspeicherchips enthalten bekanntlich redundante Speicherzellen, die Speicherzellen des Speicherfeldes ersetzen, wenn beim Testen des Halbleiterspeicherchips fehlerhafte Speicherzellen festgestellt werden. Wird beispielsweise bei diesem Testen eine fehlerhafte Speicherzelle in einer Wortleitung festgestellt, dann wird die Funktion aller Speicherzellen dieser Wortleitung durch redundante Speicherzellen ersetzt. Die Adresse der so ersetzten Wortleitung muß abgespeichert werden, damit dann, wenn eine Speicherzelle dieser Wortleitung angesteuert wird, ein Umschalten auf die redundante Wortleitung vorgenommen werden kann. Für diese Abspeicherung werden Latches (Zwischenspeicher) und Fuses herangezogen: die Latches speichern zwischen, welche Leitungen durch redundante Leitungen zu ersetzen sind, verlieren diese Information aber bei Abschaltung des Halbleiterspeicherchips. Daher ist die Information über die Zuordnung von redundanten Speicherzellen bzw. -leitungen zu fehlerhaften Speicherzellen bzw. Wortleitungen und Bitleitungen dauerhaft in den Fuses abgelegt.

Diese Fuses sind auf dem Halbleiterspeicherchip zusammen mit den Speicherzellen des Speicherfeldes und den redundanten Speicherzellen integriert und werden beim Testen des Halbleiterspeicherchips mittels eines Laserstrahles oder Stromimpulses oder in sonstiger Weise getrennt, so daß durch die so "geschossenen" Fuses die Zuordnung von redundanten Speicherzellen bzw. -leitungen und fehlerhaften Speicherzellen bzw. - leitungen dauerhaft abgelegt ist.

Ein derartiges Vorgehen hat sich allgemein bewährt und wird seit längerer Zeit verbreitet angewandt. Insbesondere wurde bisher nicht daran gedacht, die Fuses durch andere Mittel zu ersetzen, da dies von der Fachwelt als praktisch unmöglich angesehen wird.

Die Fuses beanspruchen relativ viel Platz auf dem Halbleiterspeicherchip. Außerdem sind Geräte zum Schießen der Fuses aufwendig, wobei dieses Schießen zudem relativ viel Zeit benötigt. Nicht zuletzt infolge dieser Nachteile haben die Erfinder Überlegungen angestellt, ob und wie gegebenenfalls das an sich seit langem bewährte Konzept der Fuses zur permanenten Speicherung der Zuordnung zwischen fehlerhaften Speicherzellen und redundanten Speicherzellen aufgegeben werden könnte.

Es ist daher Aufgabe der vorliegenden Erfindung, eine Anordnung zur Redundanzauswertung bei einem Halbleiterspeicherchip zu schaffen, die die Zuordnung zwischen fehlerhaften Speicherzellen und redundanten Speicherzellen vereinfacht und die Redundanzprogrammierung erleichtert.

Diese Aufgabe wird bei einer Anordnung zur Redundanzauswertung bei einem Halbleiterspeicherchip der eingangs genannten Art erfindungsgemäß dadurch gelöst, daß die Zuordnung zwischen redundanten Speicherzellen und ausgefallenen Speicherzellen in einem nichtflüchtigen Speicher abspeicherbar ist. Ein solcher nichtflüchtiger Speicher kann ein elektrisch löschbarer und programmierbarer Festwertspeicher, beispielsweise ein E²PROM oder ein FLASH-EPROM sein.

In vorteilhafter Weise können dabei zwischen dem Festwertspeicher und den X- und Y-Decodern noch Latches vorgesehen sein.

Bei der Erfindung übernimmt also der Festwertspeicher die Funktion der Fuses: die Lage von fehlerhaften Speicherzellen bzw. -leitungen wird zunächst - wie bisher - in Latches zwischengespeichert. Die dauerhafte Abspeicherung der Information, bei Ansteuerung welcher Wortleitungen oder Bitleitungen mit fehlerhaften Speicherzellen auf die Speicherzellen redundanter Leitungen umzuschalten ist, wird aber nicht mehr wie bisher in Fuses vorgenommen, sondern vielmehr in dem Festwertspeicher bewirkt. Es erfolgt also ein Ersatz der Fuses durch den Festwertspeicher.

Dieser Festwertspeicher, also beispielsweise ein E²PROM, wird zweckmäßigerweise in einem weiteren Halbleiterchip vorgesehen, der zusammen mit dem Halbleiterspeicherchip in einem Gehäuse untergebracht wird. Eine Integration des Halbleiterchips mit dem Festwertspeicher mit dem Halbleiterspeicherchip ist zwar an sich möglich, jedoch nicht empfehlenswert, da gerade ein als Festwertspeicher dienender E²PROM schwierig zusammen mit einem DRAM als Halbleiterspeicherchip herstellbar ist.

Ein E²PROM ist relativ einfach herstellbar und kann ohne weiteres direkt mit dem Halbleiterspeicherchip im selben Gehäuse kontaktiert werden. Da auf dem Halbleiterspeicherchip keine Fuses mehr benötigt werden - deren Funktion wird ja durch den E²PROM übernommen - kann teure Halbleiterspeicherchip-Fläche eingespart werden. Auch läßt sich die Redundanzprogrammierung mit Hilfe des E²PROMs anstelle der Fuses wesentlich schneller und einfacher durchführen, so daß zusätzlich noch Testzeit eingespart werden kann.

Die Erfindung geht also zur Redundanzprogrammierung und Auswertung von Halbleiterspeicherchips einen vollkommen neuartigen Weg: anstelle der seit längerem üblichen Fuses wird ein E²PROM verwendet, der zusammen mit dem Halbleiterspeicherchip in einem Gehäuse untergebracht und direkt mit dem Halbleiterspeicherchip verbunden wird.

Gegebenenfalls kann auch daran gedacht werden, bei einer derartigen Anordnung auf die Latches zu verzichten und bei Einspeisung von Adressen zu fehlerhaften Speicherzellen über eine entsprechende Logik mittels des E²PROMs direkt auf entsprechende redundante Speicherzellen zuzugreifen.

Nachfolgend wird die Erfindung anhand der Zeichnungen näher erläutert. Es zeigen:
- Fig. 1: ein Blockschaltbild der erfindungsgemäßen Anordnung zur Redundanzauswertung nach einem ersten Ausführungsbeispiel der Erfindung, und
- Fig. 2: ein Blockschaltbild der erfindungsgemäßen Anordnung zur Redundanzauswertung nach einem zweiten Ausführungsbeispiel der vorliegenden Erfindung.

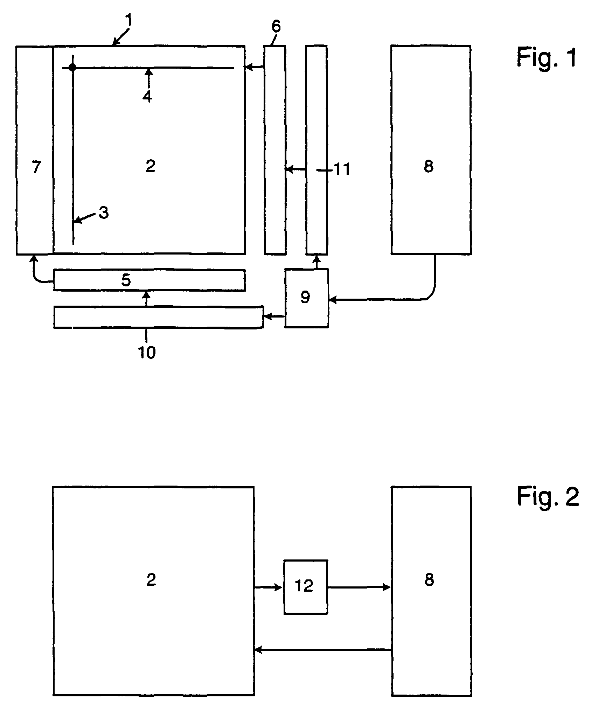

Fig. 1 zeigt einen DRAM 1 mit einem Speicherfeld 2, das eine Vielzahl (beispielsweise 8192) Wortleitungen 3 und eine entsprechende Anzahl von Bitleitungen 4 aufweist. An den Schnittpunkten von Wortleitungen 3 und Bitleitungen 4 sind jeweils Speicherzellen aus beispielsweise einem Transistor und einem Kondensator vorgesehen.

Die Wortleitungen 3 werden über einen X-Decoder 5 adressiert, während die Bitleitungen 4 über einen Y-Decoder 6 adressiert sind. Redundante Wortleitungen 7 mit entsprechenden redundanten Speicherzellen sind im gleichen Halbleiterspeicherchip 1 neben dem Speicherfeld 2 integriert. Entsprechendes gilt für redundante Bitleitungen mit entsprechenden redundanten Speicherzellen (in Fig. 1 nicht gezeigt). Die redundanten Wortleitungen 7 sind über den X-Decoder 5 angesteuert, während die redundanten Bitleitungen (in Fig. 1 nicht gezeigt) über den Y-Decoder 6 angesteuert sind.

Außerdem ist in Fig. 1 ein nichtflüchtiger Speicher in der Form eines E²PROM 8 in einem gesonderten Halbleiterchip vorgesehen, der über eine Logik 9 und Latches 10, 11 mit dem X-Decoder 5 bzw. dem Y-Decoder 6 verbunden ist. Anstelle eines E²PROM kann auch beispielsweise ein FLASH-PROM verwendet werden.

Wird beim Testen festgestellt, daß beispielsweise in der Wortleitung mit der X-Adresse ("7111") eine fehlerhafte Speicherzelle vorliegt, so wird diese Adresse "7111" im Latch 10 gesetzt und der Wortleitung 3 mit der Adresse "7111" eine redundante Wortleitung der redundanten Wortleitungen 7 zugeordnet. Zusätzlich wird die Adresse "7111" auch im E²PROM 8 auf dem Speicherplatz für die betreffende redundante Wortleitung permanent abgespeichert.

Damit bleibt auch nach einem Abschalten des Halbleiterspeicherchips 1 die Information, bei Adressierung welcher Wortleitungen und Bitleitungen redundante Wortleitungen bzw. redundante Bitleitungen zuzuschalten sind, im E²PROM 8 erhalten. Nach erneutem Einschalten des Halbleiterspeicherchips werden so durch den E²PROM die Latches 10 und 11 erneut gesetzt, so daß bei Zuführung eines externen Adressignales zu dem Decoder 5 bzw. 6 immer dann eine Umschaltung zu der entsprechenden redundanten Wortleitung bzw. redundanten Bitleitung vorgenommen wird, wenn eine fehlerhafte Leitung bzw. Speicherzelle adressiert wird.

Die Latches 10, 11 werden benötigt, um die Information des E²PROM (ca. 5000 Zellen; bei einem 64 MBit DRAM gibt es derzeit ca. 5000 Fuses und Latche) auf dem Chip bzw. Silizium des DRAMs zu speichern, wenn die Information seriell übertragen wird. Bei paralleler Übertragung, die möglich ist, wenn beispielsweise der E²PROM und der DRAM als Halbleiterspeicherchip 1 auf demselben Chip bzw. Silizium vorgesehen sind, werden die Latches 10, 11 nicht benötigt.

Fig. 2 zeigt ein weiteres Ausführungsbeispiel der erfindungsgemäßen Anordnung zur Redundanzauswertung, wobei hier über eine Logik 12 direkt in einem E²PROM mögliche Ausfälle im Speicherfeld 2 programmiert sind. Bei Einspeisung einer einer fehlerhaften Wortleitung zugeordneten Adresse erfolgt hier direkt mittels der Logik 12 eine Umschaltung auf den E²PROM, der seinerseits eine entsprechende redundante Wortleitung bzw. Bitleitung (in Fig. 2 nicht gezeigt) zuschaltet.

Durch die erfindungsgemäße Anordnung zur Redundanzauswertung kann in vorteilhafter Weise auf Fuses verzichtet werden, so daß Fläche des Halbleiterspeicherchips 1, die sonst für diese Fuses benötigt wird, eingespart werden kann. Anstelle der Fuses wird lediglich ein wenig aufwendiger E²PROM benötigt, der zweckmäßigerweise auf einem gesonderten Chip untergebracht ist und zusammen mit dem Halbleiterspeicherchip 1 im gleichen Gehäuse untergebracht wird und dort direkt diesen Halbleiterchip 1 kontaktiert. Die Programmierung des E²PROM 8 anstelle von Fuses läßt sich wesentlich rascher und einfacher ausführen, so daß zusätzlich Testzeit eingespart werden kann.

## Patentansprüche

1. Anordnung zur Redundanzauswertung bei einem Halbleiterspeicherchip (1) mit Speicherzellen, die matrixartig in einem Speicherfeld (2) angeordnet sind, das über einen ersten und einen zweiten Decoder (5, 6) ansteuerbar ist, und mit redundanten Speicherzellen (7), die bei Ausfall von Speicherzellen des Speicherfeldes (2) deren Funktion übernehmen, wobei die Zuordnung zwischen redundanten Speicherzellen (7) und ausgefallenen Speicherzellen in einem Speicher (8) abspeicherbar ist,
**dadurch gekennzeichnet,** daß
der Speicher ein nichtflüchtiger Speicher (8) ist und zwischen dem nichtflüchtigen Speicher (8) und dem ersten bzw. zweiten Decoder (5, 6) Latches (10, 11) vorgesehen sind.

2. Anordnung nach Anspruch 1,
**dadurch gekennzeichnet,** daß
der Halbleiterspeicherchip (1) und der nichtflüchtige Speicher (8) in einem gemeinsamen Gehäuse in unterschiedlichen Chips vorgesehen sind.

3. Anordnung nach Anspruch 1,
**dadurch gekennzeichnet,** daß
der Halbleiterspeicherchip (1) und der nichtflüchtige Speicher (8) in einem Chip vorgesehen sind.

4. Anordnung nach einem der Ansprüche 1 bis 3,
**dadurch gekennzeichnet,** daß
bei Ausfall einer Speicherzelle alle Speicherzellen der zugehörigen Leitung (3, 4) durch die redundanten Speicherzellen (7) ersetzbar sind.
